# EUROPEAN PATENT APPLICATION

(11) **EP 4 332 276 A1**
(43) Date of publication of application: **06.03.2024**
(21) Application number: 22849902.6
(22) Date of filing: 28.07.2022
(51) Int. Cl.: C25D 11/12, C25D 11/18, H05K 5/04

(54) **METHOD FOR MANUFACTURING ANODIZABLE ALUMINUM EXTERIOR MATERIAL, AND ELECTRONIC DEVICE INCLUDING SAME**

(30) Priority: 28.07.2021 KR 20210099150
(71) Applicant: Samsung Electronics Co., Ltd., Suwon-si, Gyeonggi-do 16677 (KR)
(72) Inventor: HEO, Sungyoung, Suwon-si, Gyeonggi-do 16677 (KR); PARK, Hyungki, Suwon-si, Gyeonggi-do 16677 (KR); KIM, Jongbo, Suwon-si, Gyeonggi-do 16677 (KR); LIM, Jiho, Suwon-si, Gyeonggi-do 16677 (KR); JUNG, Youngsoo, Suwon-si, Gyeonggi-do 16677 (KR)
(74) Representative: Appleyard Lees IP LLP
(86) International application number: PCT/KR2022/011122
(87) International publication number: WO 2023/008926

(57) **Abstract**

An electronic device according to various embodiments disclosed herein comprises: a display; and a housing including the display, wherein at least a portion of the housing includes an aluminum alloy processed into a designated shape, a first film layer formed on the aluminum alloy, and a second film layer formed between the aluminum alloy and the first film layer. The first coating layer may be formed on the aluminum alloy by a first anodizing process using a first voltage, and the second coating layer may be formed on the aluminum alloy by a second anodizing process using a second voltage after performing the first anodizing process.

## Description

### [Technical Field]

Various embodiments of the disclosure relate to a method for manufacturing an aluminum exterior material that can be anodized, and an electronic device including the same.

### [Background Art]

As information/communication technologies and, semiconductor technologies have developed, various types of electronic devices have been widespread and used at a rapid pace. Particularly, recent electronic devices have been developed to be carried and used for communication.

Electronic devices may refer to devices configured to perform specific functions according to installed programs, such as home appliances, electronic wallets, portable multimedia players, mobile communication terminals, tablet PCs, video/audio devices, desktop/laptop computers, and vehicle navigation systems. For example, electronic devices may output stored information as sounds or images. In line with the high degree of integration of electronic devices and the widespread use of super-fast large-capacity wireless communication, it has recently become possible to equip a single electronic device (for example, mobile communication terminal) with various functions. For example, not only a communication function, but also an entertainment function (for example, gaming), a multimedia function (for example, music/video playback), communication and security functions for mobile banking and the like, a scheduling function, and an electronic wallet function may be integrated into a single electronic device. Such electronic devices have become compact such that users can conveniently carry the same.

Recently, aluminum metals have been used extensively as exterior materials for high quality of the portable electronic devices. In general, aluminum metals are lightweight metal materials which have been used most by mankind so far, and which are applied in many fields. Particularly, aluminum alloy materials use aluminum as the major constituent component and include, as major alloy elements, copper, magnesium, manganese, silicon, tin, or zinc.

Various types of surface treatment methods exist to use the aluminum alloy materials as exterior materials, and anodizing, among the same, is a surface treatment method using such characteristics that a metal is electrically connected to an anode to oxidate the metal surface by oxygen generated by the anode, thereby generating an aluminum oxide film. If an aluminum alloy material is anodized, an oxide film (Al₂O₃) having a nanometer-sized diameter grows uniformly up to tens of micrometers, and the generated oxide film has a high level of hardness, thereby improving the wear resistance of aluminum. The surface of an anodized metal retains the texture unique to the metal, thereby improving the aesthetic appeal, and can prevent corrosion, thereby having excellent anti-corrosion characteristics.

### [Detailed Description of the Invention]

### [Technical Problem]

Recently, portable electronic device aluminum alloy exterior materials are increasingly required to have various textures of exterior design and color implementation together with strength, wear resistance, corrosion resistance, or electric insulation.

Conventional anodizing methods have problems in that the gloss unique to metals restricts implementation of various colors (for example, low chroma) or texture implementation, an additional process such as sanding or etching is necessary for texture implementation, and this increases costs and makes quality management difficult.

A physical method for implementing various textures is sanding, various media/process conditions (for example, pressure, velocity, distance) may be used, if necessary, to implement the texture and exterior, and etching, which is a chemical method, may be used to control the gloss or texture according to the state (for example, temperature, concentration, activity) of a chemical. However, additional treatment and processes may increase costs, generate stains, and cause a difference in quality between products.

A method for manufacturing an aluminum exterior material through anodizing treatment and an electronic device including the same, according to various embodiments of the disclosure, may implement a haze effect and pastel color without adding physical/chemical processes through anodizing treatment using primary and secondary variable constant voltages when an oxide film is generated on the surface of an aluminum alloy material.

However, problems to be solved in the disclosure are not limited to the above-mentioned problems, and may be variously expanded without deviating from the idea and scope of the disclosure.

### [Technical Solution]

An electronic device according to various embodiments of the disclosure may include: a display; and a housing including the display, at least a portion of the housing including an aluminum alloy machined to have a designated shape; a first film layer formed on the aluminum alloy; and a second film layer formed between the aluminum alloy and the first film layer, wherein the first film layer is formed by a first anodizing process using a first voltage on the aluminum alloy, and the second film layer is formed by a second anodizing process using a second voltage on the aluminum alloy after the first anodizing process.

A method for machining an aluminum exterior material according to various embodiments of the disclosure may include: machining an aluminum alloy into a designated shape; and anodizing the machined aluminum alloy, wherein the anodizing includes performing first anodizing using a first voltage on the machined aluminum alloy to form a first film layer on the machined aluminum alloy; and performing second anodizing using a second voltage on the machined aluminum alloy to form a second film layer on the machined aluminum alloy after the first anodizing is performed, and wherein the second film layer is positioned between the first film layer and the machined aluminum alloy.

A housing of an electronic device according to various embodiments of the disclosure may have at least a portion including: an aluminum alloy machined to have a designated shape; a first film layer formed on the aluminum alloy; and a second film layer formed between the aluminum alloy and the first film layer, wherein the first film layer is formed by a first anodizing process using a first voltage on the aluminum alloy, and the second film layer is formed by a second anodizing process using a second voltage on the aluminum alloy after the first anodizing process.

### [Advantageous Effects]

An electronic device and a method for machining an aluminum exterior material according to various embodiments of the disclosure use primary and secondary variable constant voltages (voltages changed once) when an oxide film is generated to implement haze and low-chroma (pastel) color such that no physical/chemical process is added, thereby incurring no cost, and enables stable quality management while retaining the merits of conventional anodizing.

Before undertaking the detailed description below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely.

Moreover, various functions described below can be implemented or supported by one or more computer programs, each of which is formed from computer readable program code and embodied in a computer readable medium. The terms "application" and "program" refer to one or more computer programs, software components, sets of instructions, procedures, functions, objects, classes, instances, related data, or a portion thereof adapted for implementation in a suitable computer readable program code. The phrase "computer readable program code" includes any type of computer code, including source code, object code, and executable code. The phrase "computer readable medium" includes any type of medium capable of being accessed by a computer, such as read only memory (ROM), random access memory (RAM), a hard disk drive, a compact disc (CD), a digital video disc (DVD), or any other type of memory. A "non-transitory" computer readable medium excludes wired, wireless, optical, or other communication links that transport transitory electrical or other signals. A non-transitory computer readable medium includes media where data can be permanently stored and media where data can be stored and later overwritten, such as a rewritable optical disc or an erasable memory device.

Definitions for certain words and phrases are provided throughout this patent document, those of ordinary skill in the art should understand that in many, if not most instances, such definitions apply to prior, as well as future uses of such defined words and phrases.

### [Brief Description of Drawings]

For a more complete understanding of the present disclosure and its advantages, reference is now made to the following description taken in conjunction with the accompanying drawings, in which like reference numerals represent like parts:
FIG. 1 is a block diagram illustrating an electronic device 101 in a network environment according to various embodiments of the disclosure;
FIG. 2 is a front perspective view of an electronic device according to various embodiments of the disclosure;
FIG. 3 is a rear perspective view of an electronic device according to various embodiments of the disclosure;
FIG. 4 is an exploded perspective view of an electronic device according to various embodiments of the disclosure;
FIG. 5 is a flowchart illustrating a method for manufacturing a sheet by using an aluminum alloy according to various embodiments of the disclosure;
FIG. 6 is a diagram illustrating a method for performing an anodizing process on an aluminum alloy material according to various embodiments of the disclosure;
FIG. 7 is a diagram illustrating a relationship between a primary voltage and a secondary voltage during an anodizing process according to various embodiments of the disclosure;
FIG. 8 is a diagram illustrating an oxidation film including multiple layers formed on a surface of an aluminum alloy material after an anodizing process according to various embodiments of the disclosure;
FIG. 9 is a diagram illustrating that a haze effect appears on a surface of an aluminum alloy material after an anodizing process according to various embodiments of the disclosure;
FIG. 10 is a diagram illustrating that a haze effect is implemented according to a time of applying a secondary constant voltage according to various embodiments of the disclosure;
FIG. 11 is a diagram illustrating that glossiness of a surface of an aluminum alloy material changes according to a time of applying a secondary constant voltage according to various embodiments of the disclosure;
FIG. 12 is a diagram illustrating a surface of an aluminum alloy material before and after applying a secondary constant voltage according to various embodiments of the disclosure;
FIG. 13 is an enlarged diagram of a surface of an aluminum alloy material according to a time of applying a secondary constant voltage according to various embodiments of the disclosure;
FIG. 14A and FIG. 14B are diagrams illustrating a time for a haze effect to develop according to a change in magnitude of a primary constant voltage when a secondary constant voltage is applied according to various embodiments of the disclosure; and
FIGs. 15A, 15B, 15C and 15D are diagrams illustrating a change in thickness of a grain boundary according to a change in magnitude of a primary constant voltage when a secondary constant voltage is applied according to various embodiments of the disclosure.

### [Mode for Carrying out the Invention]

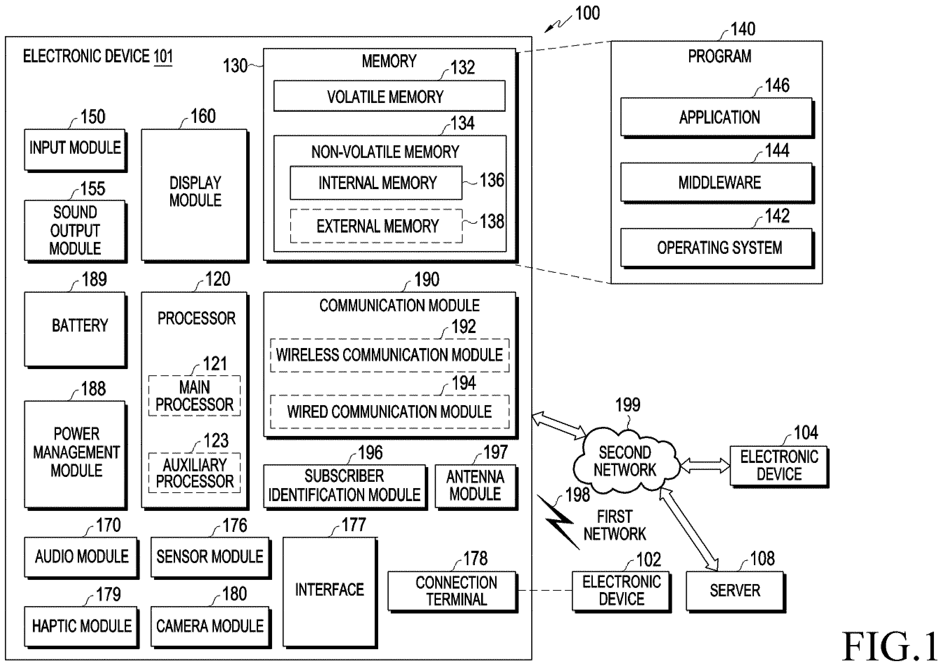

FIGS. 1 through 15D, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged system or device.

FIG. 1 is a block diagram illustrating an electronic device in a network environment according to various embodiments of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

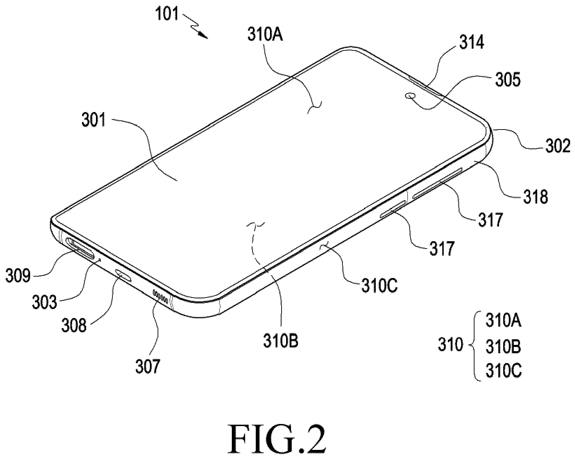

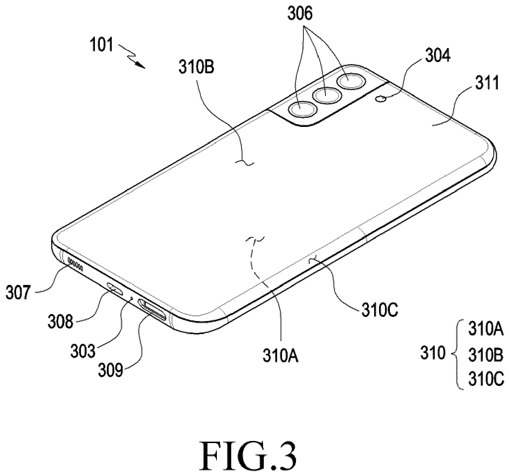

FIG. 2 is a front perspective view of an electronic device 101 according to various embodiments of the disclosure. FIG. 3 is a rear perspective view of an electronic device 101 according to various embodiments of the disclosure.

Referring to FIG. 2 and FIG. 3, the electronic device 101 according to an embodiment may include a housing 310 including a front surface 310A, a rear surface 310B, and a lateral surface 310C surrounding a space between the front surface 310A and the rear surface 310B. According to another embodiment (not shown), the housing 310 may refer to a structure for configuring a portion of the front surface 310A in FIG. 2, and the rear surface 310B and the lateral surface 310C in FIG. 3. According to an embodiment, at least a portion of the front surface 310A may be formed by a substantially transparent front plate 302 (e.g., a glass plate including various coating layers or polymer plate). The rear surface 310B may be formed of a rear plate 311. The rear plate 311 may be formed by, for example, glass, ceramic, polymers, metals (for example, aluminum, stainless steel (STS), or magnesium), or a combination of at least two thereof. The lateral surface 310C may be coupled to the front plate 302 and the rear plate 311 and formed by a lateral bezel structure (or a "lateral member") 318 including a metal and/or polymer. In an embodiment, the rear plate 311 and the lateral bezel structure 318 may be integrally formed and include the same material (for example, glass, a metal material such as aluminum, or ceramic). According to another embodiment, the front surface 310A and/or the front plate 302 may include a portion of a display 301.

According to an embodiment, the electronic device 101 may include at least one of a display 301, an audio module 303, 307, or 314 (for example, the audio module 170 of FIG. 1), a sensor module (for example, the sensor module 176 of FIG. 1), a camera module 305 or 306 (for example, the camera module 180 of FIG. 1), a key input device 317 (for example, the input module 150 of FIG. 1), and a connector hole 308 or 309 (for example, the connection terminal 178 of FIG. 1). In an embodiment, the electronic device 101 may omit at least one of the components (for example, the connector hole 309) or additionally include another component. According to an embodiment, the display 301 may be visually exposed to outside through, for example, a substantial portion of the front plate 302.

According to an embodiment, the surface (or the front plate 302) of the housing 310 may include a screen display area formed by visually exposing the display 301. By way of example, the screen display area may include the front surface 310A.

According to another embodiment (not shown), the electronic device 101 may include a recess or an opening formed on a portion of the screen display area (for example, the front surface 310A) of the display 301, and include at least one of the audio module 314, the sensor module (not shown), a light-emitting element (not shown), and the camera module 305, which is aligned with the recess or the opening. In another embodiment (not shown), the display 301 may include at least one of the audio module 314, the sensor module (not shown), the camera module 305, a fingerprint sensor (not shown), and the light-emitting element (not shown) on the back surface of the screen display area.

According to another embodiment (not shown), the display 301 may be combined to or disposed adjacent to a touch sensing circuit, a pressure sensor for measuring a strength (pressure) of a touch, and/or a digitizer for detecting a magnetic field-type stylus pen.

According to an embodiment, at least a portion of the key input device 317 may be disposed on the lateral bezel structure 318.

According to an embodiment, the audio module 303, 307, or 314 may include, for example, a microphone hole 303 and a speaker hole 307 or 314. A microphone for obtaining a sound from outside may be disposed in the microphone hole 303 and in an embodiment, multiple microphones may be arranged to detect a direction of a sound. The speaker hole 307 or 314 may include an outer speaker hole 307 and a receiver hole 314 used for calling. In an embodiment, the speaker hole 307 or 314 and the microphone hole 303 may be implemented into one hole and a speaker may be included without a speaker hole 307 or 314 (for example, a piezo speaker).

According to an embodiment, a sensor module (not shown) may generate an electrical signal or a data value corresponding to, for example, an internal operation state or external environment state of the electronic device 101. The sensor module (not shown) may include a first sensor module (not shown) (for example, a proximity sensor) disposed on the front surface 310A of the housing 310 and/or a second sensor module (not shown) (for example, a fingerprint sensor). The sensor module (not shown) may include a third sensor module (not shown) (for example, an HRM sensor) disposed on the rear surface 310B of the housing 310 and/or a fourth sensor module (not shown) (for example, a fingerprint sensor). According to another embodiment (not shown), the fingerprint sensor may be disposed at the rear surface 310B as well as at the front surface 310A (for example, the display 301) of the housing 310. The electronic device 101 may further include at least one sensor module not shown in the drawings, for example, a gesture sensor, a gyro sensor, an air pressure sensor, a magnetic sensor, an acceleration sensor, a grip sensor, a color sensor, an infrared (IR) sensor, a biometric sensor, a temperature sensor, humidity sensor, or an illuminance sensor (not shown).

According to an embodiment, the camera module 305 or 306 may include a front camera module 305 disposed at the front surface 310A of the electronic device 101 and a rear camera module 306 and/or a flash 304 disposed on the rear surface 310B. The camera module 305 or 306 may include one or more of lenses, an image sensor, and/or an image signal processor. The flash 304 may include, for example, a light emitting diode or a xenon lamp. According to an embodiment, two or more lenses (infrared camera, wide-angle, and telephoto lens) and image sensors may be arranged on one surface of the electronic device 101.

According to an embodiment, the key input device 317 may be disposed on the lateral surface 310C of the housing 310. According to another embodiment, the electronic device 101 may not include a portion or the entirety of the key input device 317 described above, and the excluded key input device 317 may be implemented as various forms such as a soft key on the display 301.

According to an embodiment, the light emitting element (not shown) may be disposed on, for example, the front surface 310A of the housing 310. The light emitting element may provide state information of the electronic device 101 in a form of light, for example. According to another embodiment, the light emitting element (not shown) may provide, for example, a light source interlocking with an operation of the front camera module 305. The light emitting element (not shown) may include, for example, a light-emitting diode (LED), an infrared LED (IR LED), and/or a xenon lamp.

According to an embodiment, the connector hole 308 and 309 may include, for example, a first connector hole 308 capable of receiving a connector (for example, a USB connector) for transmitting or receiving power and/or data to or from an external electronic device or a connector (for example, an earphone jack) for transmitting or receiving an audio signal to or from an external electronic device, and/or a second connector hole 309 capable of receiving a storage device (for example, a subscriber identification module (SIM) card). According to an embodiment, the first connector hole 308 and/or the second connector hole 309 may be omitted.

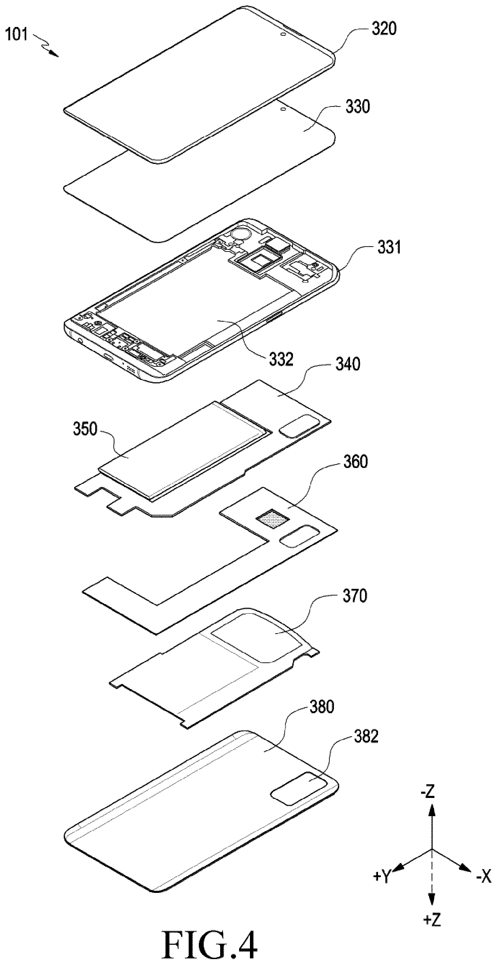

FIG. 4 is an exploded perspective view of an electronic device according to various embodiments of the disclosure.

Referring to FIG. 4, the electronic device 101 (for example, the electronic device 101 in FIG. 2 and FIG. 3) may include at least one from among a front plate 320 (for example, the front plate 302 in FIG. 2), a display 330 (for example, the display 301 in FIG. 2), a first support member 332 (for example, a bracket), a printed circuit board 340, a battery 350, a second support member 360 (for example, a rear case), an antenna 370, and a rear plate 380 (for example, the rear plate 311 in FIG. 3). In an embodiment, the electronic device 101 may omit at least one of the components (for example, the first support member 332 or the second support member 360) or additionally include another component. At least one of the components of the electronic device 101 may be the same as or similar to at least one of the components of the electronic device 101 in FIG. 2 or FIG. 3, and thus an overlapping description thereof will be omitted.

According to an embodiment, the first support member 332 may be disposed in the electronic device 101 to be connected to the lateral bezel structure 331 or integrally formed with the lateral bezel structure 331. The first support member 332 may be formed of, for example, a metal material and/or a non-metal (for example, a polymer) material. The first support member 332 may have the display 330 coupled to one surface thereof and the printed circuit board 340 coupled to the other surface thereof. A processor, a memory, and/or an interface may be mounted on the printed circuit board 340. The processor may include, for example, one or more of a central processing device, an application processor, a graphic process device, an image signal processor, a sensor hub processor, or a communication processor. According to an embodiment, the memory may include, for example, a volatile memory or a nonvolatile memory. According to an embodiment, the interface may include, for example, a high-definition multimedia interface (HDMI), a universal serial bus (USB) interface, an SD card interface, and/or an audio interface. The interface, for example, may electrically or physically connect the electronic device 101 and an external electronic device, and may include a USB connector, an SD card/MMC connector, or an audio connector. According to an embodiment, the battery 350 (for example, the battery 189 in FIG. 1) is a device for supplying power to at least one component (for example, the camera module 305 or 306) of the electronic device 101, and may include a non-rechargeable primary battery, a rechargeable secondary battery, or a fuel cell. At least a portion of the battery 350 may be disposed on a substantially identical plane to the printed circuit board 340. The battery 350 may be disposed and integrally formed in the electronic device 101 or may be disposed to be attachable to/detachable from the electronic device 101.

According to an embodiment, the second support member 360 (for example, the rear case) may be disposed between the printed circuit board 340 and the antenna 370. For example, the second support member 360 may include one surface to which at least one of the printed circuit board 340 or the battery 350 is coupled and the other surface to which the antenna 370 is coupled.

According to an embodiment, the antenna 370 may be disposed between the rear plate 380 and the battery 350. The antenna 370 may include, for example, a near field communication (NFC) antenna, a wireless charge antenna, and/or a magnetic secure transmission (MST) antenna. The antenna 370 may wirelessly transmit and receive power used for charging or perform near field communication with an external device, for example. For example, the antenna 370 may include a coil for wireless charging. In another embodiment, an antenna structure may be formed by a portion or a combination of the lateral bezel structure 331 and/or the first support member 332.

According to various embodiments, an electronic device 101 may include a camera module (for example, the camera module 306 of FIG. 3) disposed in the housing (for example, the housing 310 in FIG. 2). According to an embodiment, the camera module 306 may be disposed on the first support member 332 and may be a rear camera module (for example, the camera module 306 in FIG. 3) capable of obtaining an image of a subject located on a rear side (for example, the +Z direction) of the electronic device 101. According to an embodiment, at least a portion of the camera module 306 may be exposed outside the electronic device 101 through the opening 382 formed through the rear plate 380.

The electronic device 101 disclosed in FIG. 2 to FIG. 4 has a bar type or a plate type appearance, but the disclosure is not limited thereto. For example, the electronic device illustrated herein may be a rollable electronic device or a foldable electronic device. The "rollable electronic device" may refer to an electronic device in which a display (for example, the display 330 in FIG. 3) is bendable and transformable so that at least a portion thereof can be wound or rolled to be received in a housing (for example, the housing 310 in FIG. 2). According to user needs, a screen display area of the rollable electronic device may be expanded to be used by unfolding the display or by exposing a larger area of the display to the outside. The "foldable electronic device" may refer to an electronic device in which different two areas of the display may be folded in a direction to face each other or in a direction to face opposite directions from each other. Generally, in a mobile state, the different two areas of the display of the foldable electronic device are folded in a direction to face each other or in a direction to face away from each other, and in an actual use state, a user may unfold the display to make the two different areas form a substantially flat plate shape. In an embodiment, the electronic device 101 according to various embodiments of the disclosure may include various electronic devices such as a laptop computer or a camera as well as a mobile electronic device such as a smartphone.

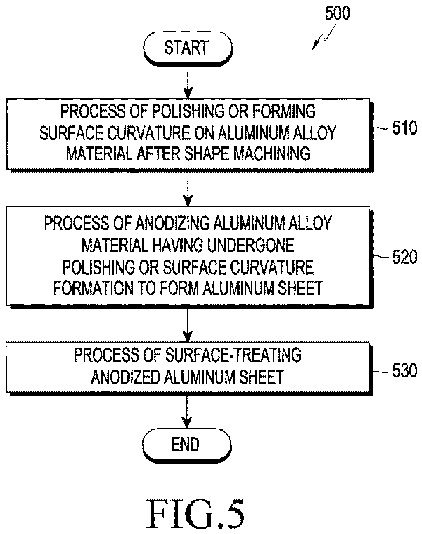

FIG. 5 is a flowchart illustrating a method 500 for manufacturing a sheet by using an aluminum alloy according to various embodiments of the disclosure.

Referring to FIG. 5, as at least a portion of the housing (for example, the housing 310 in FIG. 2 to FIG. 3) of the electronic device (for example, the electronic device 101 in FIG. 1 to FIG. 4), an aluminum sheet used as an exterior material or an interior material may be manufactured according to a process of forming surface curvature or polishing an aluminum alloy material after a shape machining (process 510), a process of anodizing the aluminum alloy material having undergone the polishing or the surface curvature formation to form an aluminum sheet (process 520), and a process of surface-treating the anodized aluminum sheet (process 530).

According to various embodiments, process 510 may include a polishing process and/or a surface curvature formation process which is performed on an aluminum alloy material after a shape machining.

According to various embodiments, the polishing process is performed to implement high glossiness on a surface of an aluminum sheet to be applied to the electronic device, and a method for polishing may include a physical polishing process and/or an electro polishing process.

According to various embodiments, in the polishing process, an electro polishing process may be performed after a physical polishing process is performed. For another example, a physical polishing process may be performed after an electro polishing process is performed. For another example, a physical polishing process and an electro polishing process may be selectively performed.

According to various embodiments, a physical polishing process may be performed by contacting rotatable polishing equipment to the surface of the aluminum alloy material. For example, the polishing equipment may be configured by attaching a member capable of causing physical friction, such as by polishing fabric, paper, leather, and/or a polymer to a jig movable in a horizontal and/or vertical direction.

According to various embodiments, the polishing may be performed by pressurizing and rotating a polishing cloth of the polishing equipment at a predetermined pressure on the surface of the aluminum alloy material seated on the jig of the polishing equipment. The rotation speed and pressure of the polishing equipment pressurizing the aluminum alloy material may be variously changed according to configuration of a user. The physical polishing process may selectively use a wet polishing in which polishing is performed in a wet state of the surface of the aluminum alloy material and a dry polishing in which polishing is performed in a dry state of the surface of the aluminum alloy material. For another example, the wet polishing and the dry polishing may be performed in parallel.

According to various embodiments, when moving between the polishing processes, a cleaning process may be included in a time period before the polishing process and/or between multiple times of polishing processes. The surface glossiness of the surface of the aluminum alloy material may be achieved more efficiently through the cleaning process.

According to various embodiments, a surface curvature formation process may be performed after a polishing process (for example, the physical polishing and/or electro polishing process) is performed on the aluminum alloy material. The surface curvature formation process may be performed after the physical polishing process is performed or after the electro polishing process is performed. For another example, the surface curvature formation process may be performed after the physical polishing process and the electro polishing process are sequentially performed, or may be performed without the polishing processes having been performed.

According to various embodiments, the surface curvature formation process is performed to implement high glossiness on a surface of an aluminum sheet to be applied to the electronic device, and may include a method of physically applying force and/or a method of chemically applying force.

According to various embodiments, an anodizing process may be performed on the aluminum alloy material to which the polishing process or the surface curvature formation have been performed according to process 520. The anodizing process may be performed after the polishing process is performed or after the surface curvature formation process is performed. For another example, the anodizing process may be performed after the surface curvature formation process and the polishing process are sequentially performed, or may be performed without the polishing process or the surface curvature formation process having been performed.

According to various embodiments, the anodizing process may include preprocessing (cleaning), desmutting, anodizing, dyeing, sealing, and/or eluting process. For another example, the anodizing process may include treatment (cleaning) performed by using a metallic color of the aluminum alloy material 110 itself, anodizing, sealing, and/or eluting process.

According to various embodiments, the preprocessing process may be performed to remove oil fractions (for example, cutting oil, and gloss residues, and the like) and impurities remaining on the surface of the aluminum alloy material to be applied to the electronic device and may include a degreasing process and/or a cleaning process as a cleaning method. The degreasing process according to various embodiments may include an acidic degreasing (for example, pH 7.0 or less), an alkaline degreasing (for example, pH 7.0 or more), or neutral series, and may apply precipitation time and/or temperature conditions compatible for the characteristics and specifications of the aluminum alloy material.

According to various embodiments, the desmutting process may be performed to remove metal impurities remaining on the surface of the aluminum alloy material to be applied to the electronic device and to adjust the surface, and may be performed after the preprocessing process is performed.

According to various embodiments, in the desmutting process, for example, sulfuric acid or nitric acid as an acidic solution is used, the concentration thereof satisfies about 5g/L to 800g/L, the temperature satisfies room temperature or higher, and the precipitation time falls within about 5 seconds to 30 minutes so as to be compatible for the characteristics and specifications of the aluminum alloy material.

The anodizing process according to various embodiments may be performed to form an oxidation film on the surface of the aluminum alloy material, and may be performed by preparing equipment for receiving an electrolyte including at least one of or all of sulfuric acid, oxalic acid, phosphoric acid, or chromic acid, inputting an aluminum alloy material into the electrolyte, and providing a predetermined voltage and temperature.

In the anodizing process according to various embodiments, the dyeing process may provide various colors to the completed aluminum sheet. For example, in the dyeing process, dye coloring may be performed by an aqueous method in which an organic dye is dissolved in water to deposit a material after primary and secondary oxidation films are formed. A temperature of a coloration tank may be about 30 to 60°C and a dye concentration may be adjusted in a range of about 0.1 g/L to 10 g/L by adding the dye as necessary.

Hereinafter, according to various embodiments of the disclosure, a concrete method for producing an oxidation film structure including multiple layers by using a variable voltage during oxidation film formation according to the anodizing process so as to give a haze effect will be described.

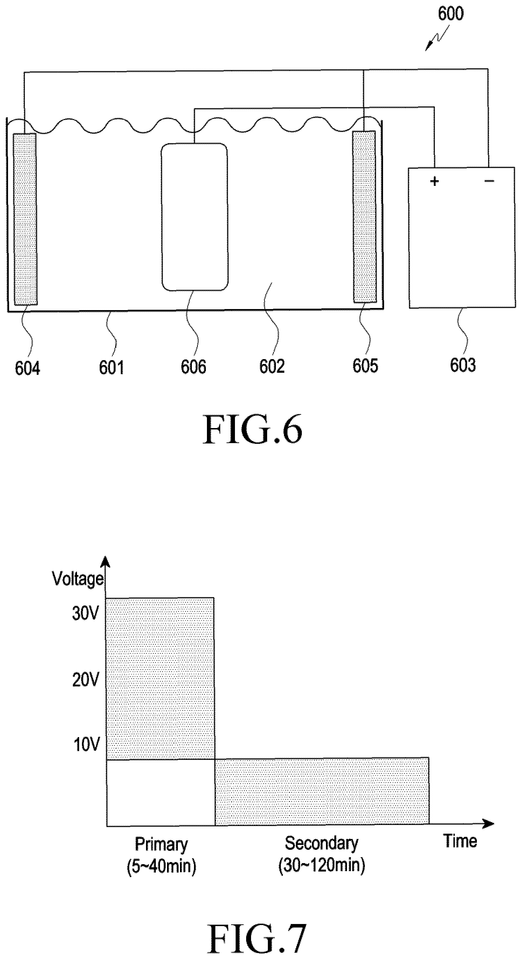

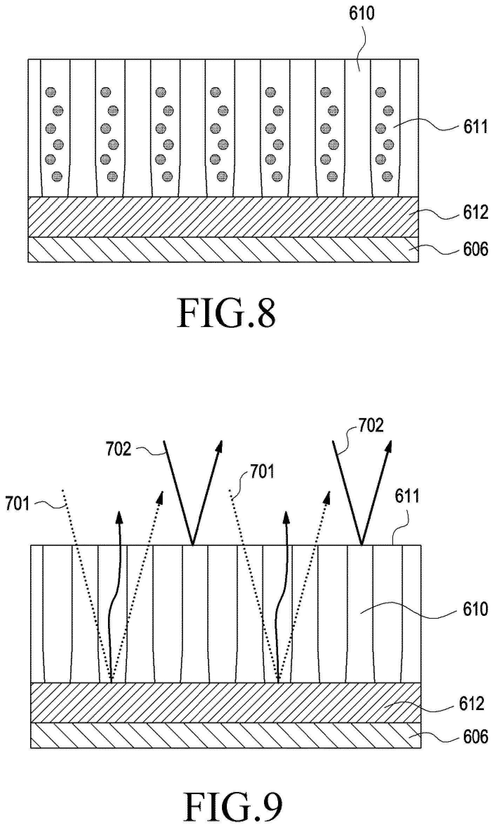

FIG. 6 is a diagram illustrating a method for performing an anodizing process on an aluminum alloy material according to various embodiments of the disclosure. FIG. 7 is a diagram illustrating a relationship between a primary voltage and a secondary voltage during an anodizing process according to various embodiments of the disclosure. FIG. 8 is a diagram illustrating an oxidation film including multiple layers formed on a surface of an aluminum alloy material after an anodizing process according to various embodiments of the disclosure. FIG. 9 is a diagram illustrating that a haze effect appears on a surface of an aluminum alloy material after an anodizing process according to various embodiments of the disclosure.

Referring to FIG. 6 to FIG. 9, the anodizing process 600 may be performed by filling an electrolyte container 601 with an electrolyte 602, connecting each of a first electrode 604 and a second electrode 605 to a negative electrode ((-) electrode) of a battery 603 and immersing at least a portion of the electrodes into the electrolyte 602, immersing the entirety of an aluminum alloy material 606 connected to a positive electrode ((+) electrode) of the battery 603 into the electrolyte 602 between the first electrode 604 and the second electrode 605, and sequentially applying a primary constant voltage and a secondary constant voltage through the battery 603. According to an embodiment, a first oxidation film 610 may be formed on the surface of the aluminum alloy material 606 by the primary constant voltage. According to an embodiment, the first oxidation film 610 may include multiple film pores 611. According to an embodiment, a second oxidation film 612 may be formed on the surface of the aluminum alloy material 606 by the secondary constant voltage after the primary constant voltage has been applied. According to an embodiment, the second oxidation film 612 may be formed right on the surface of the aluminum alloy material 606 to be positioned between the first oxidation film 610 and the surface of the aluminum alloy material 606. According to an embodiment, after the anodizing process 600, a first light 701 reflected by the second oxidation film 612 under the multiple film pores 611 included in the first oxidation film 610 and a second light 702 diffusely reflected from a surface of the first oxidation film 610 may cause a haze effect to be implemented. According to an embodiment, a pastel color may be implemented by the coloration in the multiple film pores 611 included in the first oxidation film 610.

According to various embodiments, the electrolyte 602 used in the anodizing process 600 may include at least one or all of sulfuric acid, oxalic acid, phosphoric acid, or chromic acid. For example, sulfuric acid having a concentration of about 150 g/L to 300 g/L may be used as the electrolyte 602.

According to various embodiments, the anodizing process 600 may be performed at a temperature of about 25 degrees or lower. For example, the anodizing process 600 may be performed at a temperature range of about 0 to 25 degrees.

According to various embodiments, the primary constant voltage may be applied within a range satisfying a predetermined condition according to a desired thickness of the first oxidation film 610. For example, the primary constant voltage may be applied in a range of about 10 V to 30 V within about 5 to 40 minutes based on the desired first oxidation film 610 thickness of 5 to 20 µm.

According to various embodiments, after the primary constant voltage is applied, the secondary constant voltage may be applied to be lower than the primary constant voltage. For example, the secondary constant voltage may be applied within about 1 V to 10 V. According to an embodiment, as a time of applying the secondary constant voltage increases, the second oxidation film 612 may be formed to implement a haze effect on the surface of the aluminum alloy material 606.

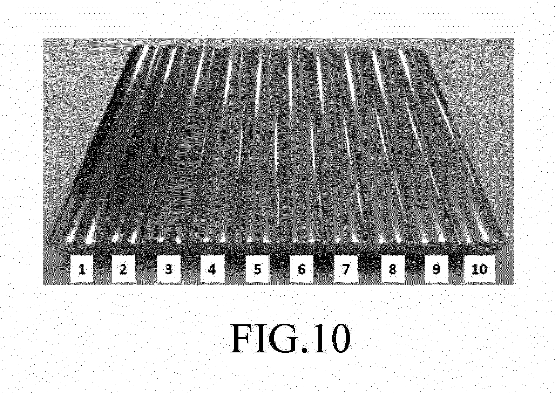

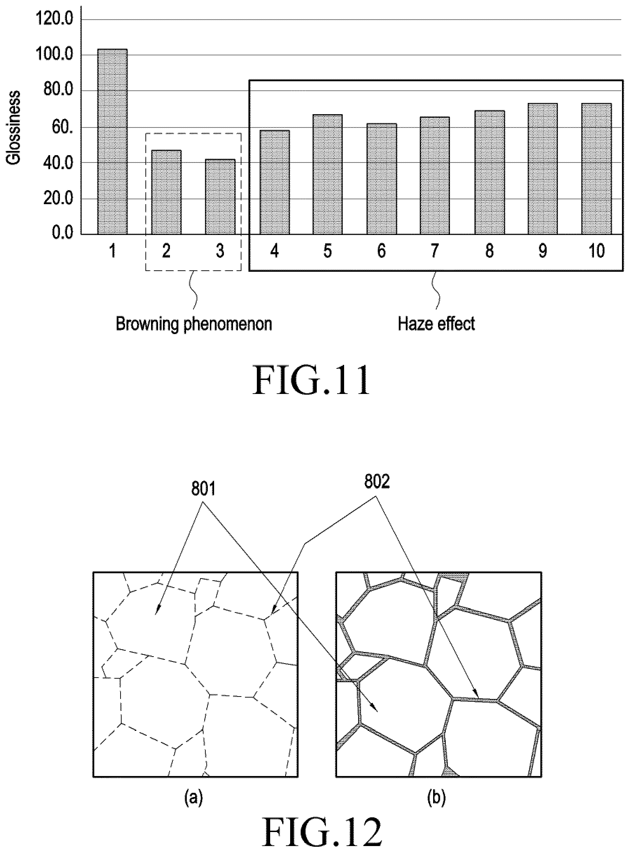

FIG. 10 is a diagram illustrating that a haze effect is implemented according to a time of applying a secondary constant voltage according to various embodiments of the disclosure. FIG. 11 is a diagram illustrating that glossiness of a surface of an aluminum alloy material changes according to a time of applying a secondary constant voltage according to various embodiments of the disclosure.

FIG. 10 and FIG. 11 show a case in which the primary constant voltage is about 13 V and the secondary constant voltage is about 7 V. The numbers shown in FIG. 10 and FIG. 11 indicate a state according to a time of applying the secondary constant voltage and that the larger the number is, the larger the time of applying the constant voltage. For example, number 1 indicates a state in which the secondary constant voltage is applied for about 10 minutes (hereinafter, number 1 state), number 2 indicates a state in which the secondary constant voltage is applied for about 20 minutes (hereinafter, number 2 state), and number 10 indicates a state in which the secondary constant voltage is applied for about 100 minutes (hereinafter, number 10 state).

Referring to FIG. 10, as a result of applying the secondary constant voltage, browning and/or surface change occurs on the surface of the aluminum alloy material in number 1 state to number 3 state corresponding to initial states, and a haze effect is confirmed to be implemented after number 4 state. After number 4 state in which the haze effect is implemented, as the time of applying the secondary constant voltage increases, that is, the number increases, it may be confirmed that the phenomenon of implementing the haze effect becomes clearer.

Referring to FIG. 11, as a result of applying the secondary constant voltage, the initial glossiness of number 1 state corresponding to the initial state is 100 GU, the glossiness of number 2 and number 3 states in which browning and/or surface change occurs decrease to about 50% of the initial glossiness, and after number 4 state, it is confirmed that the stable appearance is implemented as the glossiness increases from number 2 and number 3 states to about 60% to 80% of the initial glossiness.

FIG. 12 illustrates a surface of an aluminum alloy material before and after applying a secondary constant voltage according to various embodiments of the disclosure. The part (a) of FIG. 12 shows the surface of the aluminum alloy material in the initial state before applying the secondary constant voltage and the part (b) of FIG. 12 shows the surface of the aluminum alloy material in a state in which the haze effect is implemented by applying the secondary constant voltage.

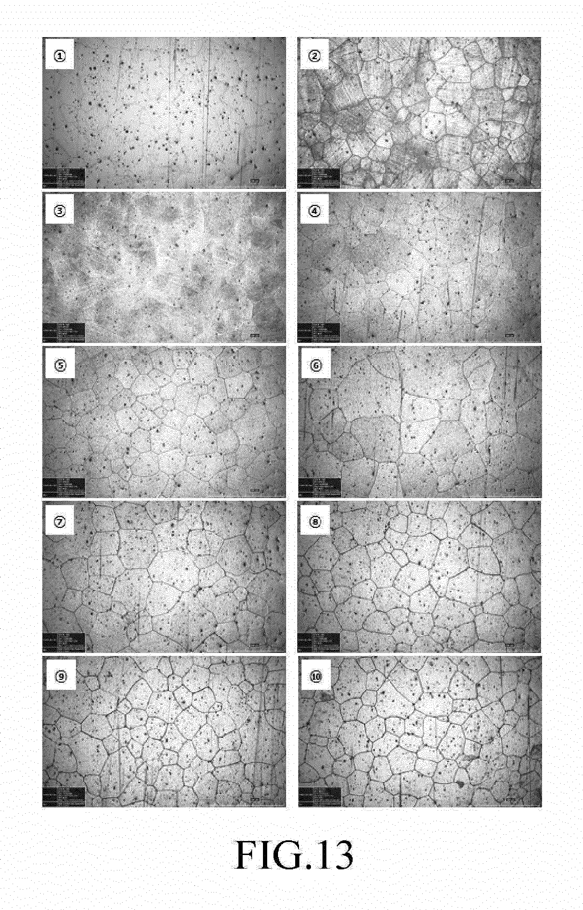

FIG. 13 is an enlarged diagram of a surface of an aluminum alloy material according to a time of applying a secondary constant voltage according to various embodiments of the disclosure. FIG. 13 shows a case in which the primary constant voltage is about 13 V and the secondary constant voltage is about 7 V. The numbers shown in FIG. 13 indicate a state according to a time of applying the secondary constant voltage and that the larger the number is, the larger the time of applying the constant voltage. For example, number 1 indicates a state in which the secondary constant voltage is applied for about 10 minutes (hereinafter, number 1 state), number 2 indicates a state in which the secondary constant voltage is applied for about 20 minutes (hereinafter, number 2 state), and number 10 indicates a state in which the secondary constant voltage is applied for about 100 minutes (hereinafter, number 10 state).

Referring to FIG. 12, it is noted that the surface of the aluminum alloy material does not show clear distinction between grains 801 and a grain boundary 802 which is a boundary between grains does not exist in the initial state before the secondary constant voltage is applied, but shows clear distinction between grains 801 and the grain boundary 802 exists in a state in which the haze effect is implemented by applying the secondary constant voltage.

Referring to FIG. 13, it is confirmed that in number 1 state corresponding to the initial state while the secondary constant voltage is applied, the distinction between grains is not clear and the grain boundary which is the boundary between grains does not exist. It may be confirmed that in number 2 state to number 3 state in which the browning phenomenon and/or surface change occurs, the distinction between grains is possible and the grain boundary exists and then as time passes, it is difficult to distinguish between grains and the grain boundary have disappeared. It may be confirmed that after number 4 state in which the haze effect begins to be implemented, the distinction between grains is partially possible and the grain boundary exists, and after number 7 state, the distinction between grains and the grain boundary are clearer so that the haze effect is implemented by diffused reflection of light from the surface of aluminum.

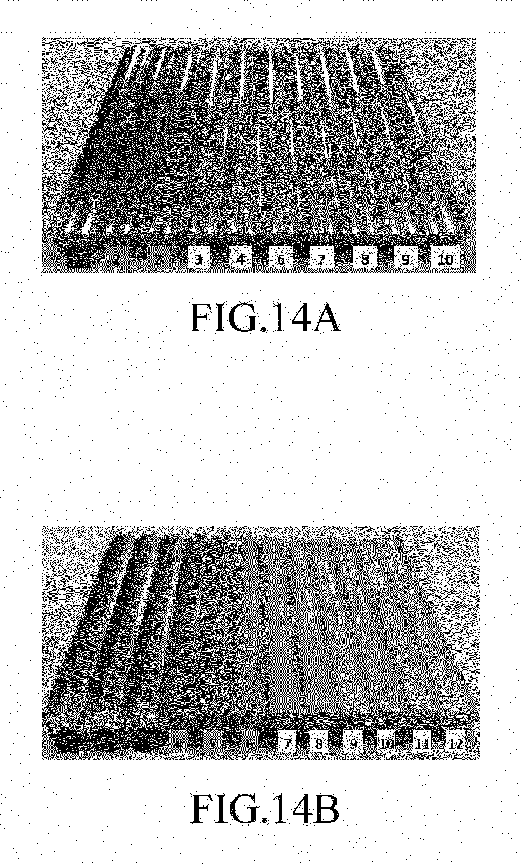

FIG. 14A, FIG. 14B, and Table 1 show a time for a haze effect to develop according to a change in magnitude of a primary constant voltage when a secondary constant voltage is applied according to various embodiments of the disclosure.

FIG. 14A shows a case in which the primary constant voltage has a magnitude of about 13 V and the secondary constant voltage has a magnitude of about 7 V in Table 1, and FIG. 14B shows a case in which the primary constant voltage has a magnitude of about 18 V and the secondary constant voltage has a magnitude of about 7 V in Table 1.

**Table 1**

| Primary constant voltage | Secondary constant voltage | Time for developing haze effect | |
|---|---|---|---|
| | | Not implemented-Browning period | Haze implementation period |
| 13 V | 7 V | 0-30 min. | 40-120 min. |
| 14 V | 7 V | 0-30 min. | 40-120 min. |
| 15 V | 7 V | 0-40 min. | 50-120 min. |
| 17 V | 7 V | 0-50 min. | 60-120 min. |
| 18 V | 7 V | 0-60 min. | 70-120 min. |

Referring to Table 1, it may be confirmed that when the secondary constant voltage is about 7 V, in a case in which the primary constant voltage is about 13 V and 14 V, the period in which the browning phenomenon occurs in the initial state is up to about 30 minutes and the haze effect occurs after 40 minutes, in a case in which the primary constant voltage is about 15 V, the period in which the browning phenomenon occurs in the initial state is up to about 40 minutes and the haze effect occurs after 50 minutes, in a case in which the primary constant voltage is about 17 V, the period in which the browning phenomenon occurs in the initial state is up to about 50 minutes and the haze effect occurs after 60 minutes, and in a case in which the primary constant voltage is about 18 V, the period in which the browning phenomenon occurs in the initial state is up to about 60 minutes and the haze effect occurs after 70 minutes, and thus it may be confirmed that as the primary constant voltage increases, the time of applying the secondary constant voltage to implement the haze effect increases.

Referring to FIG. 14A and FIG. 14B, when comparing the haze effect on the same number in FIG. 14A and FIG. 14B in which the haze effect is implemented, it may be confirmed that the haze effect is more intense than that of FIG. 14A in FIG. 14B, where the primary constant voltage is larger. Here, the more intense haze effect means the lower glossiness, and thus it may be confirmed that the glossiness may be adjusted through the magnitude of the primary constant voltage.

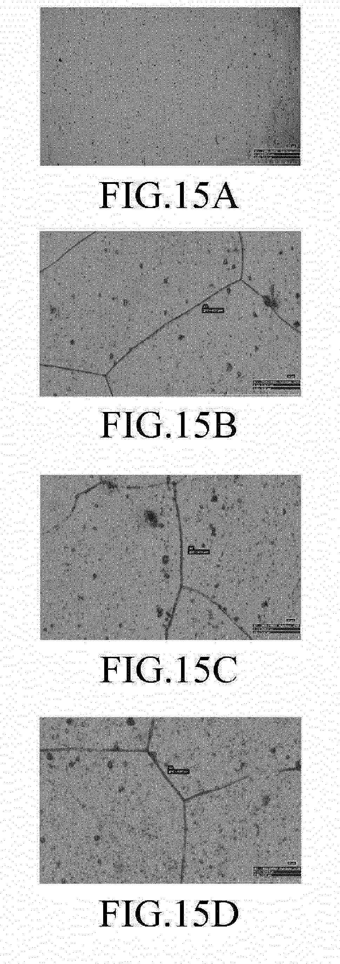

FIGs. 15A, 15B, 15C, 15D and Table 2 show a change in thickness of a grain boundary according to a change in magnitude of a primary constant voltage when a secondary constant voltage is applied according to various embodiments of the disclosure.

FIG. 15A shows a case in which only the primary constant voltage is applied in Table 2, FIG. 15B shows a case in which the primary constant voltage has a magnitude of about 13 V and the secondary constant voltage has a magnitude of about 7 V in Table 2, FIG. 15C shows a case in which the primary constant voltage has a magnitude of about 15 V and the secondary constant voltage has a magnitude of about 7 V in Table 2, and FIG. 15D shows a case in which the primary constant voltage has a magnitude of about 17 V and the secondary constant voltage has a magnitude of about 7 V in Table 2.

**Table 2**

| Classification | Grain boundary measurement result |
|---|---|
| Single voltage | Not measured |
| Primary constant voltage: 13 V | 0.57 µm |
| Secondary constant voltage: 7 V | |
| Primary constant voltage: 15 V | 0.71 µm |
| Secondary constant voltage: 7 V | |
| Primary constant voltage: 17 V | 0.97 µm |
| Secondary constant voltage: 7 V | |

Referring to FIGs. 15A, 15B, 15C, 15D and Table 2, it may be confirmed that in the case in which only the primary constant voltage is applied, the distinction between grains is not clear and the grain boundary does not exist, in the case in which the primary constant voltage is about 13 V, the thickness of the grain boundary is about 0.57 µm, in the case in which the primary constant voltage is about 15 V, the thickness of the grain boundary is about 0.71 µm, and in the case in which the primary constant voltage is about 17 V, the thickness of the grain boundary is about 0.97 µm. It may be confirmed that as the primary constant voltage increases, the thickness of the grain boundary increases, and according thereto, more diffused reflection from the surface of the aluminum alloy material occurs so that the haze effect may be more intense.

Table 3 shows an effect according to a magnitude and time of applying the primary constant voltage and the secondary constant voltage according to various embodiments of the disclosure.

**Table 3 [129]**

| | Voltage | Time |
|---|---|---|
| Primary constant voltage | Haze intensity determination (Control of glossiness) | Target thickness determination (Satisfaction of corrosion resistance, light resistance, etc.) |
| Secondary constant voltage | Haze implementation (Specific voltage range) | Haze implementation (Application time needs to be satisfied) |

Referring to Table 3, the intensity of the haze effect may be determined by the voltage magnitude of the primary constant voltage so as to control the glossiness, and the thickness of a primary oxidation film may be determined by the time of applying the primary constant voltage so as to satisfy corrosion resistance and/or light resistance. The voltage magnitude of the secondary constant voltage can be selected to satisfy a specific voltage range in order to develop the haze effect, and the time of applying the secondary constant voltage can be selected to satisfy an application time of a predetermined value or more in order to develop the haze effect.

An electronic device (for example, the electronic device 101 in FIG. 1 to FIG. 4) according to various embodiments of the disclosure may include: a display (for example, the display 301 in FIG. 2 and FIG. 3 and 330 in FIG. 4); and a housing (for example, the housing 310 in FIG. 2 and FIG. 3) including the display, at least a portion of the housing including: an aluminum alloy (for example, the aluminum alloy material 606 in FIG. 6 to FIG. 9) machined to have a designated shape; a first film layer (for example, the first oxidation film 610 in FIG. 8 and FIG. 9) formed on the aluminum alloy; and a second film layer (for example, the second oxidation film 612 in FIG. 8 and FIG. 9) formed between the aluminum alloy and the first film layer, wherein the first film layer may be formed by a first anodizing process using a first voltage on the aluminum alloy, and the second film layer may be formed by a second anodizing process using a second voltage on the aluminum alloy after the first anodizing process.

In the electronic device (for example, the electronic device 101 in FIG. 1 to FIG. 4) according to various embodiments, the first film layer may include multiple film pores (for example, 611 in FIG. 8 and FIG. 9).

In the electronic device (for example, the electronic device 101 in FIG. 1 to FIG. 4) according to various embodiments, a range of the first voltage may satisfy 10 V to 30 V.

In the electronic device (for example, the electronic device 101 in FIG. 1 to FIG. 4) according to various embodiments, a range of the second voltage may satisfy 1V to 10 V.

In the electronic device (for example, the electronic device 101 in FIG. 1 to FIG. 4) according to various embodiments, a time during which the first voltage is applied may be determined according to a thickness of the first film layer.

In the electronic device (for example, the electronic device 101 in FIG. 1 to FIG. 4) according to various embodiments, a thickness of the first film layer may satisfy a range of 5 µm to 20 µm.

In the electronic device (for example, the electronic device 101 in FIG. 1 to FIG. 4) according to various embodiments, a time during which the first voltage is applied may satisfy a range of 5 to 40 minutes.

In the electronic device (for example, the electronic device 101 in FIG. 1 to FIG. 4) according to various embodiments, a time during which the second voltage is applied may be determined according to a magnitude of the first voltage in order to develop a haze effect.

In the electronic device (for example, the electronic device 101 in FIG. 1 to FIG. 4) according to various embodiments, a time during which the second voltage is applied may satisfy a range of 30 to 120 minutes.

A method for machining an aluminum exterior material (for example, the method 500 in FIG. 5) according to various embodiments of the disclosure may include: a process of machining an aluminum alloy into a designated shape; and process of anodizing the machined aluminum alloy (for example, the process 520 in FIG. 5), wherein the process of anodizing may include: a process of performing a first anodizing process using a first voltage on the machined aluminum alloy to form a first film layer on the machined aluminum alloy; and a process of performing a second anodizing process using a second voltage on the machined aluminum alloy to form a second film layer on the machined aluminum alloy after the first anodizing is performed, and wherein the second film layer may be positioned between the first film layer and the machined aluminum alloy.

The method for machining an aluminum exterior material (for example, the method 500 in FIG. 5) according to various embodiments may further include a process of polishing or forming surface curvature on the machined aluminum alloy (for example, the process 510 in FIG. 5).

The method for machining an aluminum exterior material (for example, the method 500 in FIG. 5) according to various embodiments may further include a process of surface-treating the anodized aluminum alloy (for example, the process 530 in FIG. 5) formed by the first anodizing process and the second anodizing process.

In the method for machining an aluminum exterior material (for example, the method 500 in FIG. 5) according to various embodiments, the first anodizing process and the second anodizing process may further include preprocessing, dyeing, sealing, and eluting processes.

In the method for machining an aluminum exterior material (for example, the method 500 in FIG. 5) according to various embodiments, the first film layer may include multiple film pores.

In the method for machining an aluminum exterior material (for example, the method 500 in FIG. 5) according to various embodiments, a range of the first voltage may satisfy 10 V to 30 V.

In the method for machining an aluminum exterior material (for example, the method 500 in FIG. 5) according to various embodiments, a range of the second voltage may satisfy 1V to 10 V.

In method for machining an aluminum exterior material (for example, the method 500 in FIG. 5) according to various embodiments, a time during which the first voltage is applied may be determined according to a thickness of the first film layer.

In the method for machining an aluminum exterior material (for example, the method 500 in FIG. 5) according to various embodiments, a thickness of the first film layer may satisfy a range of 5 µm to 20 µm.

In the method for machining an aluminum exterior material (for example, the method 500 in FIG. 5) according to various embodiments, a time during which the first voltage is applied may satisfy a range of 5 to 40 minutes.

In the method for machining an aluminum exterior material (for example, the method 500 in FIG. 5) according to various embodiments, a time during which the second voltage is applied may be determined according to a magnitude of the first voltage in order to develop a haze effect.

In the method for machining an aluminum exterior material (for example, the method 500 in FIG. 5) according to various embodiments, a time during which the second voltage is applied may satisfy a range of 30 to 120 minutes.

A housing (the housing 310 in FIG. 2 and FIG. 3) of an electronic device (for example, the electronic device 101 in FIG. 1 to FIG. 4) according to various embodiments of the disclosure may include at least a portion of the housing including: an aluminum alloy (for example, the aluminum alloy material 606 in FIG. 6 to FIG. 9) machined to have a designated shape; a first film layer (for example, the first oxidation film 610 in FIG. 8 and FIG. 9) formed on the aluminum alloy; and a second film layer (for example, the second oxidation film 612 in FIG. 8 and FIG. 9) formed between the aluminum alloy and the first film layer, wherein the first film layer may be formed by a first anodizing process using a first voltage on the aluminum alloy, and the second film layer may be formed by a second anodizing process using a second voltage on the aluminum alloy after the first anodizing process.

In the housing (the housing 310 in FIG. 2 and FIG. 3) of the electronic device (for example, the electronic device 101 FIG. 1 to FIG. 4) according to various embodiments, the first film layer may include multiple film pores (for example, the 611 in FIG. 8 and FIG. 9).

In the housing (the housing 310 in FIG. 2 and FIG. 3) of the electronic device (for example, the electronic device 101 FIG. 1 to FIG. 4) according to various embodiments, a range of the first voltage may satisfy 10 V to 30 V.

In the housing (the housing 310 in FIG. 2 and FIG. 3) of the electronic device (for example, the electronic device 101 FIG. 1 to FIG. 4) according to various embodiments, a range of the second voltage may satisfy 1V to 10 V.

In the housing (the housing 310 in FIG. 2 and FIG. 3) of the electronic device (for example, the electronic device 101 FIG. 1 to FIG. 4) according to various embodiments, a time during which the first voltage is applied may be determined according to a thickness of the first film layer.

In the housing (the housing 310 in FIG. 2 and FIG. 3) of the electronic device (for example, the electronic device 101 FIG. 1 to FIG. 4) according to various embodiments, a thickness of the first film layer may satisfy a range of 5 µm to 20 µm.

In the housing (the housing 310 in FIG. 2 and FIG. 3) of the electronic device (for example, the electronic device 101 FIG. 1 to FIG. 4) according to various embodiments, a time during which the first voltage is applied may satisfy a range of 5 to 40 minutes.

In the housing (the housing 310 in FIG. 2 and FIG. 3) of the electronic device (for example, the electronic device 101 FIG. 1 to FIG. 4) according to various embodiments, a time during which the second voltage is applied may be determined according to a magnitude of the first voltage in order to develop a haze effect.

In the housing (the housing 310 in FIG. 2 and FIG. 3) of the electronic device (for example, the electronic device 101 FIG. 1 to FIG. 4) according to various embodiments, a time during which the second voltage is applied may satisfy a range of 30 to 120 minutes.

The electronic device of various embodiments of the disclosure described above is not limited to the embodiments and drawings described above, and it will be apparent to those of ordinary skill in the art to which the present disclosure pertains that various substitutions, modifications, and changes are possible within the technical scope of the disclosure.

Although the present disclosure has been described with various embodiments, various changes and modifications may be suggested to one skilled in the art. It is intended that the present disclosure encompass such changes and modifications as fall within the scope of the appended claims.

## Claims

1. An electronic device comprising:
a display; and
a housing comprising the display,
at least a portion of the housing including:
an aluminum alloy machined to have a designated shape;
a first film layer formed on the aluminum alloy; and
a second film layer formed between the aluminum alloy and the first film layer,
wherein the first film layer is formed by a first anodizing process using a first voltage on the aluminum alloy, and
the second film layer is formed by a second anodizing process using a second voltage on the aluminum alloy after the first anodizing process.

2. The electronic device of claim 1,
wherein the first film layer comprises multiple film pores.

3. The electronic device of claim 1,
wherein a range of the first voltage satisfies 10 V to 30 V.

4. The electronic device of claim 1,
wherein a range of the second voltage satisfies 1V to 10 V.

5. The electronic device of claim 3,
wherein a time during which the first voltage is applied is determined according to a thickness of the first film layer.

6. The electronic device of claim 5,
wherein the thickness of the first film layer satisfies a range of 5 µm to 20 µm.

7. The electronic device of claim 6,
wherein a time during which the first voltage is applied satisfies a range of 5 minutes to 40 minutes.

8. The electronic device of claim 4,
wherein a time during which the second voltage is applied is determined according to a magnitude of the first voltage in order to develop a haze effect.

9. The electronic device of claim 8,
wherein a time during which the second voltage is applied satisfies a range of 30 minutes to 120 minutes.

10. A method for machining an aluminum exterior material, the method comprising:
machining an aluminum alloy into a designated shape; and
anodizing the machined aluminum alloy,
wherein the anodizing comprises :
performing a first anodizing process using a first voltage on the machined aluminum alloy to form a first film layer on the machined aluminum alloy; and
performing a second anodizing process using a second voltage on the machined aluminum alloy to form a second film layer on the machined aluminum alloy after the first anodizing process is performed, and
wherein the second film layer is positioned between the first film layer and the machined aluminum alloy.

11. The method of claim 10, further comprising:
polishing or forming surface curvature on the machined aluminum alloy.

12. The method of claim 10, further comprising:
surface-treating an anodized aluminum alloy formed by the first anodizing process and the second anodizing process.

13. The method of claim 10,
wherein the first anodizing process and the second anodizing process further comprise preprocessing, dyeing, sealing, and eluting processes.

14. The method of claim 10,
wherein the first film layer comprises multiple film pores.

15. The method of claim 10,
wherein a time during which the first voltage is applied is determined according to a thickness of the first film layer.
